# EUROPEAN PATENT APPLICATION

(11) **EP 1 204 123 A2**
(43) Date of publication of application: **08.05.2002**
(21) Application number: 01302816.2
(22) Date of filing: 27.03.2001
(51) Int. Cl.: H01F 10/32, H01F 41/30, H01L 43/08, H01L 43/12

(54) **Magnetoresistive film**

(30) Priority: 01.11.2000 JP 2000334557
(71) Applicant: FUJITSU LIMITED, Kawasaki-shi, Kanagawa 211-8588 (JP)
(72) Inventor: Shimizu, Yutaka, Nakahara-ku, Kawasaki-shi, Kanagawa 211 (JP); Shibata, Tatsuma, Nakahara-ku, Kawasaki-shi, Kanagawa 211 (JP)
(74) Representative: Fenlon, Christine Lesley

(57) **Abstract**

A first pinned ferromagnetic layer (46a), an antiferromagnetic bonding layer (46b) and a second pinned ferromagnetic layer (46c) are sequentially formed over an antiferromagnetic layer (45). A layered ferrimagnetic structure is established. A compound or oxide layer (51) is interposed between the antiferromagnetic bonding layer (46b) and the second pinned ferromagnetic layer (46c). The compound layer (51) serves to efficiently prevent transmission of an undulation or interfacial roughness. Undulation or interfacial roughness can be suppressed at the interface or boundary of a non-magnetic spacer layer formed on the second pinned ferromagnetic layer (46c). The magnetic interaction can thus be suppressed between the second pinned ferromagnetic layer (46c) and a free ferromagnetic layer on the non-magnetic spacer layer, irrespective of a smaller thickness of the non-magnetic spacer layer. The magnetization of the free ferromagnetic layer can thus easily rotate in response to the polarity of an applied magnetic field, irrespective of a smaller thickness of the non-magnetic spacer layer. The magnetoresistive ratio can be improved.

## Description

The present invention relates to a magnetoresistive element of the sort which is utilized to read magnetic information or binary data out of a magnetic recording medium such as a magnetic disk and a magnetic tape.

A previously-proposed magnetoresistive film comprises: an antiferromagnetic layer; a first pinned ferromagnetic layer formed to extend on the antiferromagnetic layer; an antiferromagnetic bonding layer formed to extend on the first pinned ferromagnetic layer; a second pinned ferromagnetic layer formed to extend on the antiferromagnetic bonding layer; a non-magnetic spacer layer formed to extend on the second pinned ferromagnetic layer; and a free ferromagnetic layer formed to extend on the non-magnetic spacer layer.

A method of making an antiferromagnetic layer typically includes a heat treatment effected on a material layer containing an antiferromagnetic metallic element, such as a PtMn-based alloy, a PdMn-based alloy, an NiMn-based alloy, and the like, formed on a substrate, for example. The material layer serves as a potential ferromagnetic layer. Heat serves to transform the fcc (face-centered cubic) lattice structure of the material layer into the fct (face-centered tetragonal) lattice structure. The lattice structure is thus regulated in the material layer. When the atoms are relocated in the material layer in this manner, the antiferromagnetic property develops within the material layer. An antiferromagnetic layer of a magnetoresistive film is thus obtained.

In this case, the exposed surface of the magnetoresistive film suffers from a so-called interfacial roughness in the heat treatment. The interfacial roughness of this kind is supposed to result from the relocation of the atoms within the material layer containing the antiferromagnetic metallic element. The relocation of the atoms is supposed to generate the undulation of the pinned ferromagnetic layer, the non-magnetic spacer layer and the free ferromagnetic layer, superposed in this sequence over the surface of the material layer resulting in the antiferromagnetic layer. If the non-magnetic spacer layer suffers from a larger undulation, the magnetization of the free ferromagnetic layer tends to follow the direction of the magnetization established in the pinned ferromagnetic layer. The rotation of the magnetization should be hindered in the free ferromagnetic layer.

Quite an increase in the thickness of the non-magnetic spacer layer enables the breakage of the magnetic interaction between the free and pinned ferromagnetic layers. However, the increased thickness of the non-magnetic spacer layer leads to an increased shunt current in the magnetoresistive film. Such a shunt current cannot contribute to detection of variation in the electric resistance of the magnetoresistive film. Specifically, the magnetoresistive (MR) ratio can be deteriorated in the magnetoresistive element.

Accordingly, it is desirable to provide a magnetoresistive film capable of reducing the thickness of the non-magnetic spacer layer, and at the same time, of reliably achieving an improved magnetoresistive ratio, and a method of making the same.

According to an embodiment of a first aspect of the present invention, there is provided a magnetoresistive film comprising: an antiferromagnetic layer; a first pinned ferromagnetic layer superposed on the antiferromagnetic layer; an antiferromagnetic bonding layer superposed on the first pinned ferromagnetic layer; a second pinned ferromagnetic layer superposed on the antiferromagnetic bonding layer; a non-magnetic spacer layer superposed on the second pinned ferromagnetic layer; a free ferromagnetic layer superposed on the non-magnetic spacer layer; and a compound existing between the antiferromagnetic layer and the second pinned ferromagnetic layer.

The first and second pinned ferromagnetic layers and the antiferromagnetic bonding layer in combination serve to establish a so-called layered ferrimagnetic structure. In this layered ferrimagnetic structure, the antiferromagnetic bonding layer serves to antiferromagnetically bond the first and second pinned ferromagnetic layers, irrespective of interposition of the compound. The magnetization of the second pinned ferromagnetic layer, opposed to the free ferromagnetic layer across the non-magnetic spacer layer, can reliably be fixed or pinned under the magnetic effect from the antiferromagnetic layer.

In the previously proposed system, an undulation or interfacial roughness is formed on the interface or boundary of the antiferromagnetic layer in the magnetoresistive film. The compound serves to prevent transmission of the undulation. Undulation or interfacial roughness can be suppressed on the upper and lower interfaces or boundaries of the non-magnetic spacer layer. A magnetic interaction can reliably be suppressed between the second pinned ferromagnetic layer and the free ferromagnetic layer even if the thickness of the non-magnetic spacer layer is reduced. Accordingly, the magnetization of the free ferromagnetic layer can easily be rotated in response to the polarity of an applied magnetic field, irrespective of a smaller thickness of the non-magnetic spacer layer. The magnetoresistive film is allowed to obtain a larger magnetoresistive (MR) ratio. Moreover, a smaller thickness of the non-magnetic spacer layer reliably leads to a reduced shunt current which is unable to contribute to detection of variation in the electric resistance of the magnetoresistive film.

In general, the aforementioned antiferromagnetic layer is allowed to have a regulated lattice structure, namely, the fct (face-centered tetragonal) lattice structure. The antiferromagnetic layer tends to suffer from an undulation or interfacial roughness at the interface or boundary. In the aforementioned magnetoresistive film, the compound reliably prevents transmission of the undulation or interfacial roughness from the first pinned ferromagnetic layer to the second pinned ferromagnetic layer.

The compound may comprise at least one of an oxide, a nitride, a sulfide and a carbide. Such a compound may consist of atoms or the like included in the antiferromagnetic bonding layer, and oxygen, nitrogen, sulfur or carbon atoms. In this case, the thickness of the antiferromagnetic bonding layer is preferably set in the range between 0.5nm and 0.9nm. The thickness of the non-magnetic spacer layer is preferably set in the range between 1.9nm and 2.3nm.

According to an embodiment of a second aspect of the present invention, there is provided a method of making a magnetoresistive film, comprising: forming a material layer on a substrate, said material layer containing an antiferromagnetic metallic element; forming a first pinned ferromagnetic layer on the material layer; forming an antiferromagnetic bonding layer on the first pinned ferromagnetic layer; transforming a part of the antiferromagnetic bonding layer so as to generate a transformed layer at a surface of the antiferromagnetic bonding layer; forming a second pinned ferromagnetic layer on the antiferromagnetic bonding layer; forming a non-magnetic spacer layer on the second pinned ferromagnetic layer; forming a free ferromagnetic layer on the non-magnetic spacer layer; and effecting a heat treatment on at least the material layer.

When the material layer is subjected to the heat treatment, the relocation of atoms is induced within the material layer. For example, the fcc (face-centered cubic) lattice structure is transformed into the aforementioned fct lattice structure. This relocation of the atoms allows the material layer to exhibit the antiferromagnetic property. Specifically, the material layer is transformed into an antiferromagnetic layer. At the same time, the relocation of the atoms inevitably induces undulation or interfacial roughness on the interface or boundary of the antiferromagnetic layer. The transformed layer serves to efficiently prevent transmission of the undulation or interfacial roughness from the antiferromagnetic layer to the second pinned ferromagnetic layer. Generation of an undulation or interfacial roughness can thus reliably be suppressed at the interface or boundary of the non-magnetic spacer layer.

The transformed layer may comprise at least a compound selected from a group consisting of an oxide, a nitride, a sulfide and a carbide. Such a compound can be obtained by exposing the antiferromagnetic bonding layer to a reactive gas. The reactive gas may include an O₂ gas, an N₂ gas, an SO₂ gas, an H₂S gas, a CO gas, or the like.

According to an embodiment of a third aspect of the present invention, there is provided a layered polycrystalline structure film comprising: a first ferromagnetic crystal layer; an antiferromagnetic bonding layer formed on the first ferromagnetic crystal layer based on epitaxy; a second ferromagnetic crystal layer formed on the epitaxial antiferromagnetic bonding layer based on epitaxy; and a compound existing between the antiferromagnetic bonding layer and the second ferromagnetic crystal layer.

The first and second ferromagnetic crystal layers and the antiferromagnetic bonding layer in combination serve to establish a so-called layered ferrimagnetic structure. In this layered ferrimagnetic structure, the antiferromagnetic bonding layer serves to antiferromagnetically bond the first and second ferromagnetic crystal layers, irrespective of interposition of the compound. On the other hand, the compound serves to prevent transmission of undulation or interfacial roughness. The compound efficiently prevents the transmission of an undulation or interfacial roughness between the first and second ferromagnetic crystal layers. When the interface of the first ferromagnetic crystal layer contacts an undulation or interfacial roughness, the second ferromagnetic crystal layer is reliably prevented from reflecting the undulation or interfacial roughness. To the contrary, when the interface of the second ferromagnetic crystal layer contacts an undulation or interfacial roughness, the first ferromagnetic crystal layer is reliably prevented from reflecting the undulation or interfacial roughness.

The compound may comprise at least one of an oxide, a nitride, a sulfide and a carbide. Such a compound may consist of atoms or the like included in the - antiferromagnetic bonding layer, and oxygen, nitrogen, sulfur or carbon atoms.

The magnetoresistive film of the aforementioned type can be utilized as a read head element mounted in a magnetic recording medium drive or storage device such as a magnetic disk drive, including a hard disk drive (HDD), a magnetic tape drive, and the like.

Reference will now be made, by way of example, to the accompanying drawings, in which:
Fig. 1 is a plan view schematically illustrating the structure of a hard disk drive (HDD);
Fig. 2 is an enlarged perspective view schematically illustrating the structure of a flying head slider according to a specific example;
Fig. 3 is an enlarged front view of the flying head slider for schematically illustrating a read/write electromagnetic transducer observed at the bottom surface;
Fig. 4 is an enlarged partial sectional view of the flying head slider for schematically illustrating the structure of a spin valve film;
Fig. 5 is an enlarged partial sectional view of the spin valve film for schematically illustrating the structure of a pinned ferromagnetic layer;
Fig. 6 is a perspective view schematically illustrating a material piece of a layered structure identical to that of the spin valve film;
Fig. 7 is a perspective view of a spin valve film and domain control stripe layers scraped out of the material piece;
Fig. 8 is a sectional view schematically illustrating a process of forming the material piece;
Fig. 9 is a sectional view schematically illustrating a process of generating a transformed layer or an oxide;
Fig. 10 is a sectional view schematically illustrating a process of forming the material piece after generation of the transformed layer; and
Fig. 11 is a sectional view schematically illustrating a polycrystalline structure film of a layered ferrimagnetic structure according to a specific example.

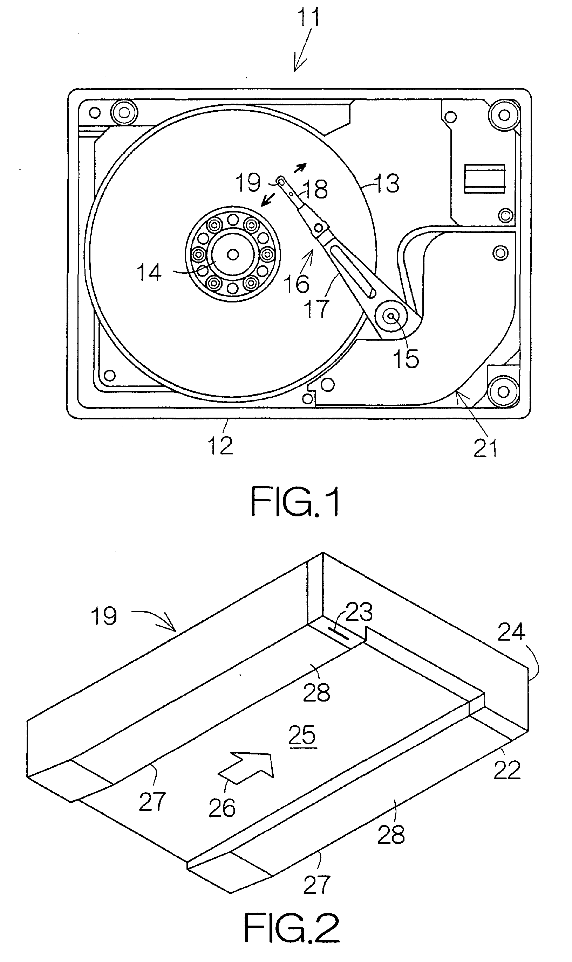

Fig. 1 schematically illustrates the interior structure of a hard disk drive (HDD) 11 as an example of a magnetic recording medium drive or storage device. The HDD 11 includes a box-shaped primary enclosure 12 defining an inner space of a flat parallelepiped, for example. At least one magnetic recording disk 13 is accommodated in the inner space within the primary enclosure 12. The magnetic recording disk 13 is mounted on a driving shaft of a spindle motor 14. The spindle motor 14 is allowed to drive the magnetic recording disk 13 for rotation at a higher revolution rate such as 7,200rpm or 10,000rpm, for example. A cover, not shown, is coupled to the primary enclosure 12 so as to define the closed inner space between the primary enclosure 12 and itself.

A carriage 16 is also accommodated in the inner space of the primary enclosure 12 for swinging movement about a vertical support shaft 15. The carriage 16 includes a rigid swinging arm 17 extending in the horizontal direction from the vertical support shaft 15, and an elastic head - suspension 18 fixed to the tip end of the swinging arm 17 so as to extend forward from the swinging arm 17. A flying head slider 19 is cantilevered at the head suspension 18 through a gimbal spring, not shown. The head suspension 18 serves to urge the flying head slider 19 toward the surface of the magnetic recording disk 13. When the magnetic recording disk 13 rotates, the flying head slider 19 is allowed to receive airflow generated along the rotating magnetic recording disk 13. The airflow serves to generate a lift on the flying head slider 19. The flying head slider 19 is thus allowed to keep flying above the surface of the magnetic recording disk 13 during rotation of the magnetic recording disk 13 at a higher stability established by the balance between the lift and the urging force of the head suspension 18.

When the carriage 16 is driven to swing about the support shaft 15 during flight of the flying head slider 19, the flying head slider 19 is allowed to cross the recording tracks defined on the magnetic recording disk 13 in the radial direction of the magnetic recording disk 13. This radial movement serves to position the flying head slider 19 right above a target recording track on the magnetic recording disk 13. In this case, an electromagnetic actuator 21 such as a voice coil motor (VCM) can be employed to realize the swinging movement of the carriage 16, for example. In the case where two or more magnetic recording disks 13 are incorporated within the inner space of the primary enclosure 12, a pair of the elastic head suspensions 18 are mounted on a single common swinging arm 17 between the adjacent magnetic recording disks 13.

Fig. 2 illustrates a specific example of the flying head slider 19. The flying head slider 19 of this type includes a slider body 22 made from Al₂O₃-TiC in the form - of a flat parallelepiped, and a head protection overcoat 24 coupled to the trailing or downstream end of the slider body 22. The head protection overcoat 24 may be made of Al₂O₃. A read/write electromagnetic transducer 23 is embedded in the head protection overcoat 24. A medium-opposed surface or bottom surface 25 is defined continuously over the slider body 22 and the head protection overcoat 24 so as to face the surface of the magnetic recording disk 13 at a distance. The bottom surface 25 is designed to receive airflow 26 generated along the surface of the rotating magnetic recording disk 13.

A pair of rails 27 are formed to extend over the bottom surface 25 from the leading or upstream end toward the trailing or downstream end. The individual rail 27 is designed to define an air bearing surface (ABS) 28 at its top surface. In particular, the airflow 26 generates the aforementioned lift at the respective air bearing surfaces 28. The read/write electromagnetic transducer 23 embedded in the head protection overcoat 24 is exposed at the air bearing surface 28 as described later in detail. The flying head slider 19 may take any shape or form other than the above-described one.

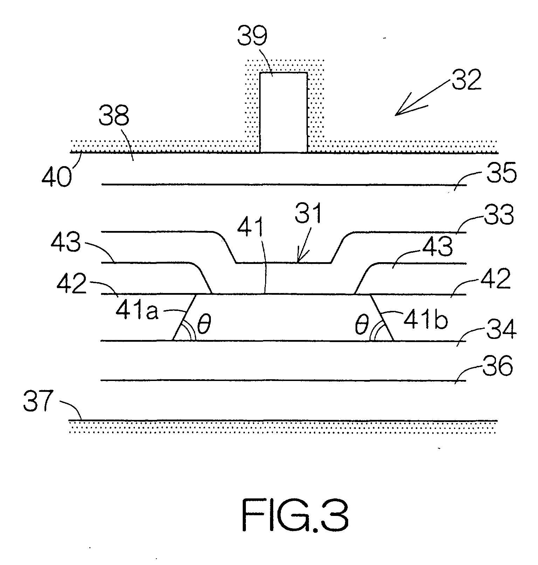

Fig. 3 illustrates an enlarged detailed view of the read/write electromagnetic transducer 23 exposed at the bottom surface 25. The read/write electromagnetic transducer 23 includes a magnetoresistive (MR) head element 31 for reading magnetic binary data out of the magnetic recording disk 13, and an inductive write element or a thin film magnetic head element 32 for recording magnetic binary data into the magnetic recording disk 13. The magnetoresistive head element 31 is designed to utilize the variation in the electric resistance induced in response to a magnetic field acting from the magnetic recording disk 13. The thin film magnetic head element 32 is designed to - utilize a magnetic field induced based on a conductive swirly coil pattern, not shown. The magnetoresistive head element 31 is interposed between upper and lower non-magnetic gap layers 33, 34 which are in turn interposed between upper and lower shield layers 35, 36. The upper and lower non-magnetic gap layers 33, 34 may be made from alumina (Al₂O₃), for example. The upper and lower shield layers 35, 36 may be made from magnetic material such as FeN and NiFe, for example. The lower shield layer 36 is allowed to spread over the surface of an alumina (Al₂O₃) layer 37.

A combination of the upper magnetic pole layer 39 and the upper shield layer 35 establishes a magnetic core of the thin film magnetic head element 32. Namely, the upper shield layer 35 of the magnetoresistive head element 31 functions as a lower magnetic pole layer of the thin film magnetic head element 32. When a magnetic field is induced at the conductive swirly coil pattern, a magnetic flux is exchanged between the upper magnetic pole layer 39 and the upper shield layer 35. The non-magnetic gap layer 38 allows the exchanged magnetic flux to leak out of the bottom surface 25. The thus leaked magnetic flux forms a magnetic field for recordation, namely, a write gap magnetic field.

The magnetoresistive head element 31 includes a magnetoresistive or spin valve film 41 extending over the non-magnetic gap layer 34 serving as a substratum. A pair of end surfaces 41a, 41b are defined on the spin valve film 41 along planes intersecting the surface of the non-magnetic layer 34. The end surfaces 41a, 41b or planes are designed to intersect the surface of the non-magnetic layer 34 by an inclined angle θ, respectively.

Likewise, a pair of magnetic stripe-layers, namely, domain control stripe layers 42, are formed on the surface of the non-magnetic gap layer 34 or the substratum so as to - interpose the spin valve film 41 therebetween along the bottom surface 25. The domain control stripe layers 42 are designed to extend on the surface of the non-magnetic gap layer 34 along the bottom surface 25. The tip ends of the respective domain control stripe layers 42 are connected to the end surfaces 41a, 41b of the spin valve film 41. A pair of conductive terminal or lead layers 43 are allowed to spread over the surface of the domain control stripe layers 42. A sensing current can be supplied to the spin valve film 41 through the conductive lead layers 43. The domain control stripe layers 42 may be made of a conductive metallic material such as CoPt, CoCrPt, and the like. The conductive terminal layers 43 may be a layered material comprising upper and lower Ta layers and a TiW layer interposed between the Ta layers.

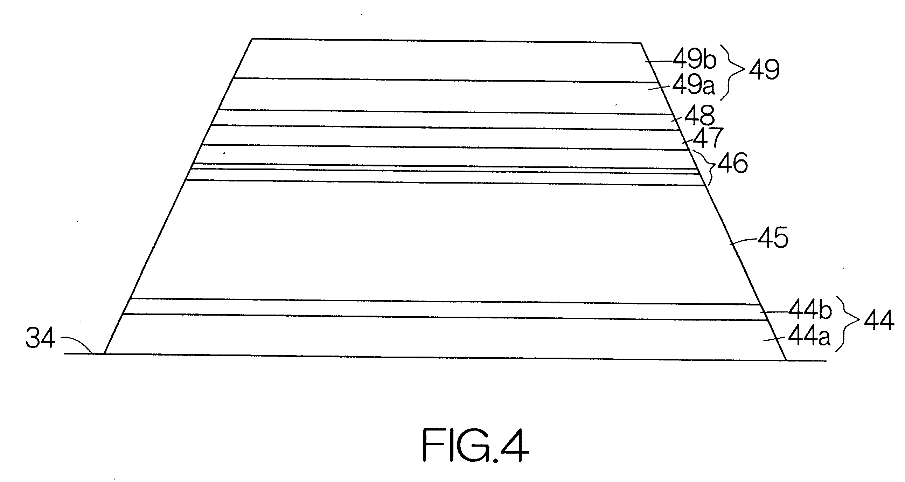

As shown in Fig. 4, the spin valve film 41 includes a basement layer 44 extending over the surface of the non-magnetic gap layer 34. The basement layer 44 may be made of a layered material including a Ta layer 44a having the thickness of approximately 5.0nm, for example, and an NiFe layer 44b of approximately 2.0nm thickness formed to extend over the surface of the Ta layer 44a.

An antiferromagnetic layer 45 as a pinning layer is superposed on the surface of the basement layer 44. The antiferromagnetic layer 45 may be made of a PdPtMn layer of approximately 15.0nm thickness, for example. The regulated lattice structure such as the fct (face-centered tetragonal) lattice structure is established in the antiferromagnetic layer 45. Alternatively, the antiferromagnetic layer 45 may be made from at least one of a PtMn-based alloy, a PdMn-based alloy and an NiMn-based alloy. An undulation or interfacial roughness is formed on the surface of the antiferromagnetic layer 45, which results from the relocation of the atoms.

A polycrystalline structure film of a layered ferrimagnetic structure, namely, a pinned ferromagnetic layer 46 is allowed to extend over the surface of the antiferromagnetic layer 45. A strong exchange coupling can thus be established between the antiferromagnetic layer 45 and the pinned ferromagnetic layer 46. Specifically, the antiferromagnetic layer 45 serves to pin or fix the magnetization of the pinned ferromagnetic layer 46 in a specific direction. As described later in detail, undulation or interfacial roughness can significantly be suppressed on the surface of the pinned ferromagnetic layer 46, as compared with the surface of the antiferromagnetic layer 45.

A non-magnetic spacer layer 47 is formed to extend over the surface of the pinned ferromagnetic layer 46. The non-magnetic spacer layer 47 may be made of a Cu layer having the thickness of approximately 2.3nm, for example. A free ferromagnetic layer 48 is superposed over the non-magnetic spacer layer 47. The free ferromagnetic layer 48 may comprise a CoFeB layer of approximately 2.0nm thickness. The surface of the free ferromagnetic layer 48 is covered with a protection layer 49, for example. The protection layer 49 may comprise a Cu layer 49a of approximately 4.0nm thickness and a Ta cap layer 49b formed on the Cu layer 49a, for example.

Accordingly, when the magnetoresistive head element 31 is opposed to the surface of the magnetic recording disk 13 for reading magnetic information data, the magnetic orientation or magnetization of the free ferromagnetic layer 48 can be rotated in the spin valve film 41 in response to change in the polarity of a magnetic field applied from the magnetic recording disk 13. The rotation of the magnetic orientation in the free ferromagnetic layer 48 induces variation in the electric resistance of the spin valve film 41. When a sensing current is supplied to the spin valve film 41 through the conductive lead layers 43, a variation in voltage appears in the sensing current, for example. The variation in voltage can be utilized to detect magnetic binary data recorded on the magnetic recording disk 13.

In this case, undulation or interfacial roughness can be suppressed on the upper and lower interfaces or boundaries of the non-magnetic spacer layer 47 in the magnetoresistive head element 31. It is possible to reliably suppress the magnetic interaction between the pinned and free ferromagnetic layers 46, 48 even if the thickness of the non-magnetic spacer layer 47 is reduced. The magnetization is allowed to easily rotate in the free ferromagnetic layer 48 in response to changes in the polarity of the magnetic field applied from the magnetic recording disk 13 irrespective of reduction in the thickness of the non-magnetic spacer layer 47. The magnetoresistive (MR) ratio can thus be improved in the magnetoresistive head element 31. The magnetoresistive head element 31 is allowed to reliably improve the sensitivity of detection. Moreover, the reduction in the thickness of the non-magnetic spacer layer 47 leads to a significant reduction of a shunt current unable to contribute to detection of variation in electric resistance.

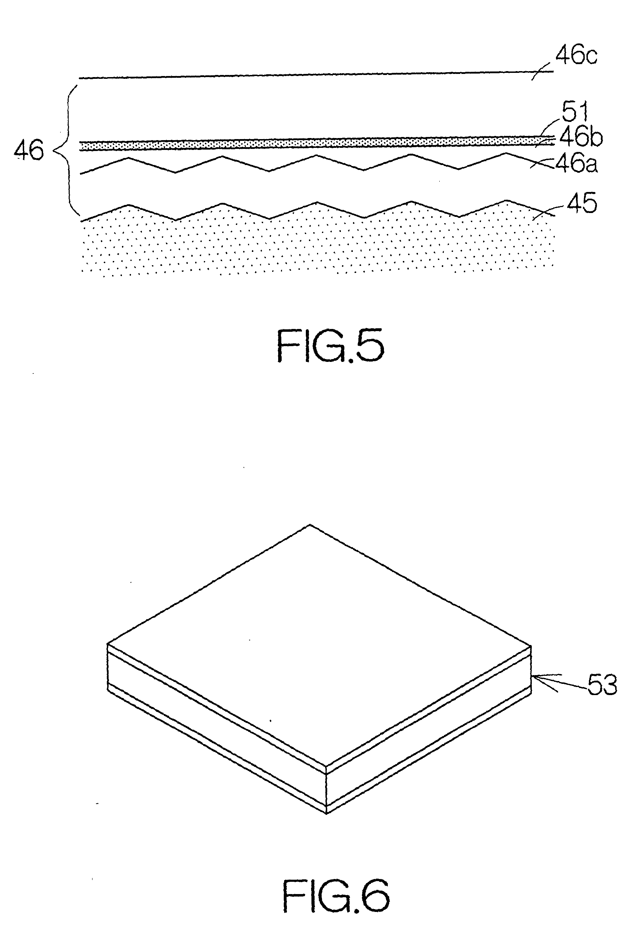

Here, a detailed description will be made of the structure of the pinned ferromagnetic layer 46. As shown in Fig. 5, the pinned ferromagnetic layer 46 includes a first ferromagnetic crystal or pinned ferromagnetic layer 46a formed to extend over the surface of the antiferromagnetic layer 45. The first pinned ferromagnetic layer 46a may be made of a CoFeB layer having a thickness - of approximately 1.5nm, for example. An undulation or interfacial roughness similar to that on the antiferromagnetic layer 45 is induced on the interface or boundary of the first pinned ferromagnetic layer 46a.

An antiferromagnetic bonding layer 46b is formed to extend over the surface of the first pinned ferromagnetic layer 46a. The antiferromagnetic bonding layer 46b may be a Ru layer, for example. The surface of the antiferromagnetic bonding layer 46b is covered with a compound layer 51. The compound layer 51 may be made from a compound such as an oxide, a nitride, a sulfide, a carbide, and the like. The compound may include Ru atoms, and oxygen, nitrogen, sulfur or carbon atoms combined with the Ru atoms. Undulation or interfacial roughness is significantly reduced on the interface or boundary of the compound layer 51, as compared with the aforementioned first pinned ferromagnetic layer 46a. The overall thickness of the antiferromagnetic bonding layer 46b and the compound layer 51 is set at approximately 0.7nm, for example.

A second pinned ferromagnetic layer 46c is formed to extend over the surface of the compound layer 51. The compound layer 51 is interposed between the antiferromagnetic bonding layer 46b and the second pinned ferromagnetic layer 46c in this manner. The second pinned ferromagnetic layer 46c may be made of a CoFeB layer of approximately 2.0nm thickness, for example. The antiferromagnetic bonding layer 46b serves to antiferromagnetically bond the second pinned ferromagnetic layer 46c to the first pinned ferromagnetic layer 46a. This bonding results in the fixed direction of the magnetization in the second pinned ferromagnetic layer 46c spaced from the free ferromagnetic layer 48. An undulation - or interfacial roughness on the second pinned ferromagnetic layer 46c is allowed to reflect the interfacial roughness of a smaller amount on the antiferromagnetic bonding layer 46b. Specifically, the undulation or interfacial roughness can significantly be suppressed on the interface or boundary of the second pinned ferromagnetic layer 46c.

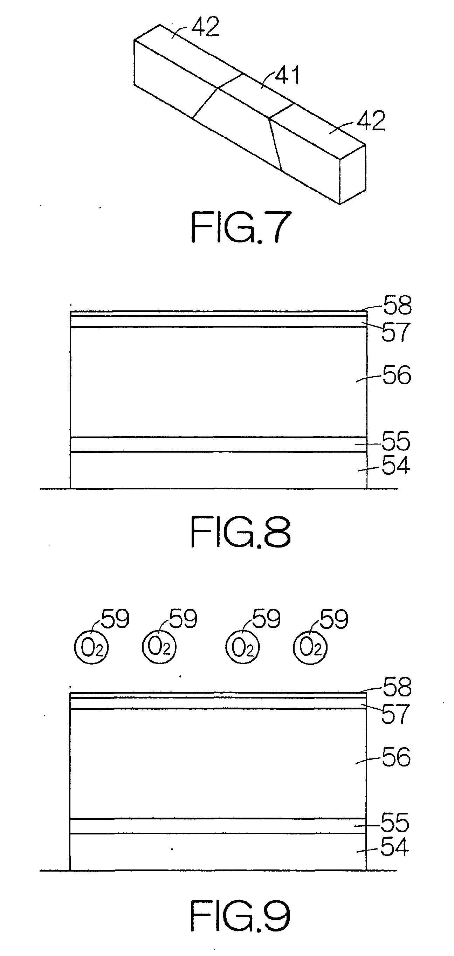

Next, a detailed description will be made of a method of making the magnetoresistive head element 31. As previously proposed, an Al₂O₃-TiC wafer, not shown, covered with the alumina layer 37 is first prepared. The lower shield layer 36 and the lower non-magnetic gap layer 34 are then formed to extend over the surface of the alumina layer 37. Subsequently, a material piece 53 is formed on the surface of the non-magnetic gap layer 34 as a substratum, as shown in Fig. 6. The material piece 53 is allowed to have a layered structure identical to that of the spin valve film 41. A detailed description will later be made on a method of making the material piece 53. As previously-proposed, the spin valve film 41 is shaped or scraped out of the material piece 53. A pair of the domain control stripe layers 42 are simultaneously scraped out adjacent to the spin valve film 41, as shown in Fig. 7. Thereafter, a pair of the conductive terminal layers 43 are formed to cover the respective domain control stripe layers 42, as previously proposed.

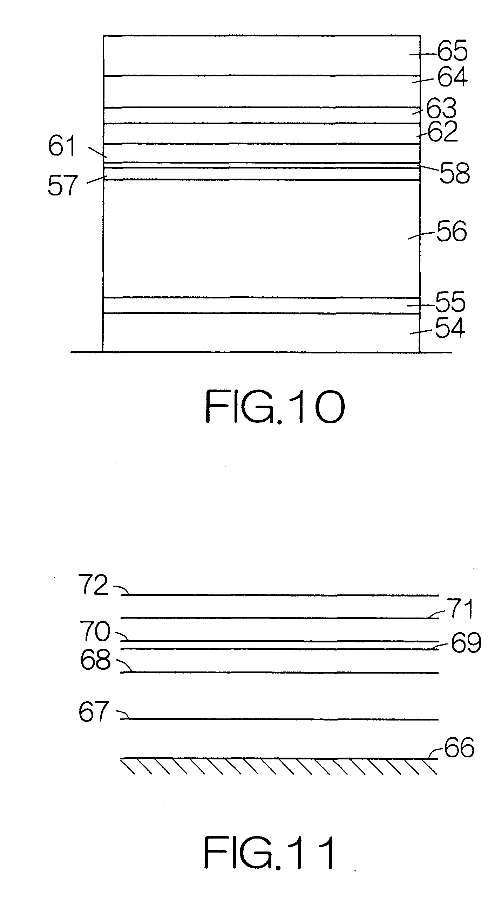

Next, a detailed description will be made of a method of making the material piece 53. As shown in Fig. 8, a Ta layer 54 and an NiFe layer 55 are sequentially formed to extend over the surface of the non-magnetic gap layer 34 on the wafer. A PdPtMn layer 56 serving as a material layer containing antiferromagnetic metallic elements is then formed to extend over the surface of the NiFe layer 55. The PdPtMn layer 56 is a polycrystalline layer having the fcc (face-centered cubic) lattice structure. Here, the Ta layer 54 and the NiFe layer 55 serve to establish the <1,1,1> orientation in the individual crystal grain. Sputtering may be employed to form the Ta layer 54, the NiFe layer 55 and the PdPtMn layer 56, for example.

Subsequently, the surface of the PdPtMn layer 56 receives lamination of a CoFeB layer 57 serving as a first ferromagnetic crystal layer and an Ru layer 58 serving as an antiferromagnetic bonding layer. The CoFeB layer 57 is allowed to grow on the PdPtMn layer 56 based on the epitaxy. Likewise, the Ru layer 58 keeps the epitaxy from the CoFeB layer 57 through the PdPtMn layer 56. Sputtering may be employed to form the CoFeB layer 57 as well as the Ru layer 58.

Thereafter, the surface of the Ru layer 58 is exposed to a reactive gas 59 such as an O₂ gas, as shown in Fig. 9, for example. The exposure of the Ru layer 58 into the O₂ gas induces a chemical reaction between the Ru atoms and the oxygen atoms. The Ru atoms are combined with the oxygen atoms so as to result in an oxide. A transformed layer consisting of the oxide can be formed on the surface of the Ru layer 58. The Ru layer 58 may be simply left in the oxygen atmosphere in generating the oxide. Alternatively, an oxygen plasma may be employed to generate the oxide. If an N₂ gas is employed in place of the O₂ gas, for example, the Ru atoms are combined with the nitride atoms so as to result in a nitride spreading over the surface of the Ru layer 58. Otherwise, if an SO₂ gas or an H₂S gas is employed as a reactive gas, the Ru atoms are combined with the sulfur atoms so as to result in a sulfide. If a CO gas is employed as a reactive gas, the Ru atoms are combined with the carbon atoms so as to result in a carbide. The compound may sparsely exist on the surface - of the Ru layer 58, or cover all over the surface of the Ru layer 58, so as to form a transformed layer.

When the transformed layer has been established on the surface of the Ru layer 58 in the above-described manner, a CoFeB layer 61 as a second ferromagnetic crystal layer, a Cu layer 62 as a non-magnetic spacer layer, and a CoFeB layer 63 as a third ferromagnetic crystal layer are sequentially formed over the Ru layer 58, as shown in Fig. 10, for example. The aforementioned epitaxy is maintained during formation of the CoFeB layer 61, the Cu layer 62 and the CoFeB layer 63. Sputtering may be employed to deposit or cumulate the CoFeB layer 61, the Cu layer 62 and the CoFeB layer 63 in the aforementioned manner, for example. Thereafter, protection layers such as a Cu layer 64 and a Ta layer 65 are formed on the surface of the CoFeB layer 63. Sputtering may likewise be employed.

The layered polycrystalline structure film made in the above-mentioned manner is then subjected to a heat treatment. Heat of approximately 280 degrees Celsius is effected on the layered polycrystalline structure film in a vacuum condition for a duration of 3 hours, for example. The heat treatment serves to regulate the lattice structure in the potential antiferromagnetic layer, namely, the PdPtMn layer 56. The atoms are relocated within the PdPtMn layer 56. The fcc lattice structure is transformed to the fct lattice structure. When the fct lattice structure is established in the PdPtMn layer 56, the PdPtMn layer 56 is allowed to exhibit the antiferromagnetic property. Here, the layered polycrystalline structure film is simultaneously subjected to a magnetic field of 2 Tesla in the direction parallel to the surface of the wafer. The magnetic field serves to fix the direction of the magnetization along a specific direction in the first ferromagnetic crystal layer, namely, the CoFeB layer 57.

When the fct lattice structure is established in the above-described manner, an undulation or interfacial roughness is induced on the surface of the PdPtMn layer 56, namely, the antiferromagnetic layer based on the relocation of the atoms during the heat treatment. The undulation is transmitted to the epitaxial CoFeB and Ru layers 57, 58. However, the transformed layer at the surface of the Ru layer 58 serves to stop the transmission of the undulation. Specifically, undulation or interfacial roughness can significantly be suppressed at the surface of the Ru layer 58 to the utmost. As a result, the epitaxial CoFeB, Cu and CoFeB layers 61, 62, 63 on the Ru layer 58 can be prevented from reflecting the undulation or interfacial roughness on the PdPtMn layer 56.

The properties of the pinned ferromagnetic layer 46 and the spin valve film 41 were examined. First, specific examples equivalent to the aforementioned polycrystalline structure film of a layered ferrimagnetic structure were prepared, as shown in Fig. 11. The specific examples included a Ta layer 67 of 5.0nm thickness, a Cu layer 68 of 6.0nm thickness, a CoFeB layer 69 of 3.0nm thickness, an Ru layer 70 holding an oxide at its surface, a CoFeB layer 71 of 3.0nm thickness, and a Ta layer 72 of 3.0nm thickness, formed in this sequence over an Al₂O₃-TiC wafer 66 covered with an SiO₂ lamination. The thickness of the Ru layer 70 was differently set in the individual specific examples, as is apparent from Table 1 shown below. A magnetron sputtering apparatus was employed to form the respective layers 67-72. The surface of the Ru layer 70 was simply exposed to the oxygen atmosphere so as to generate the oxide. The magnetization curves were measured in the individual specific examples. As shown in Table 1, the saturation magnetic field *Hs*[kA/m] and a ratio *Mr*/*Ms* of the residual magnetization *Mr* to the saturation magnetization *Ms* were calculated based on the measured magnetization curves.

As is apparent from Table 1, comparative examples of a polycrystalline structure film of a layered ferrimagnetic structure were also prepared. The comparative examples were designed to have an identical structure to that of the specific examples except a pure Ru layer, without an oxide, interposed between the CoFeB layers 69, 71, in place of the Ru layer 70 holding the oxide at the surface.

**[Table 1]**

| Thickness of Ru Layer [nm] | Specific Examples | | Comparative Examples | |
|---|---|---|---|---|
| | Hs [kA/m] | Mr/Ms | Hs [kA/m] | Mr/Ms |
| 0.3 | 875.4 | 0.3 | 954.9 | 0.2 |
| 0.5 | 477.5 | 0 | 437.7 | 0 |
| 0.7 | 397.9 | 0 | 397.9 | 0 |
| 0.9 | 278.5 | 0 | 318.3 | 0 |
| 1.1 | 0.3 | 1 | 0.2 | 1 |
| 1.3 | 0.2 | 1 | 0.2 | 1 |

As is apparent from Table 1, the specific examples of the crystalline structure film exhibited values of the saturation magnetic field *Hs* and the ratio *Mr*/*Ms* that were similar to those of the comparative examples. This result has revealed that a strong antiferromagnetic bonding can be established between the CoFeB layers 69, 71, namely, between the first and second ferromagnetic crystal layers, irrespective of the interposition of the oxide or compound. Moreover, it has been confirmed that a superior *Mr*/*Ms* ratio can be obtained if the thickness of the Ru layer 70 is set in the range between 0.5nm and 0.9nm. It is preferable to set the thickness of the Ru layer 70 in the range between 0.5nm and 0.9nm in this polycrystalline structure film of a layered ferrimagnetic structure.

Next, a specific example of the aforementioned spin valve film 41 was produced. Specifically, the specific example included a Ta layer of 5.0nm thickness, a NiFe layer of 2.0nm thickness, a PdPtMn layer of 15.0nm thickness, a CoFeB layer of 1.5nm thickness, a Ru layer of 0.7nm thickness, a CoFeB layer of 2.0nm thickness, a Cu layer of 2.3nm thickness, a CoFeB layer of 2.0nm thickness, a Cu layer of 1.0nm thickness and a Ta layer, formed in this sequence over an Al₂O₃-TiC wafer covered with an SiO₂ lamination. The surface of the Ru layer was simply exposed to the oxygen atmosphere so as to generate the oxide, in the same manner as described above. After a heat treatment regulating the lattice structure in the PdPtMn layer, the magnetoresistive (MR) ratio, the exchange coupling *Hua* established between the CoFeB layers, namely, first and second pinned ferromagnetic layers 46a, 46c, and the exchange coupling *Hin* established between the CoFeB layers, namely, the pinned ferromagnetic layer 46 and the free ferromagnetic layer 48 were examined, as shown in Table 2 below.

As is apparent from Table 2, a comparative example of a spin valve film was also prepared. The comparative example was designed to have an identical structure to that of the specific example except a pure Ru layer, without an oxide, interposed between the CoFeB layers, namely, between the first and second pinned ferromagnetic layers 46a, 46c, in place of the Ru layer holding the oxide at the surface.

**[Table 2]**

| | MR Ratio [%] | Hua [kA/m] | Hin [kA/m] |
|---|---|---|---|
| Specific Example | 7.7 | 99.5 | 0.4 |
| Comparative Example | 4 | 87.5 | 6.5 |

As is apparent from Table 2, it has been confirmed that the specific example of the spin valve film 41 achieves a remarkably smaller exchange coupling *Hin* between the pinned ferromagnetic layer 46 and the free ferromagnetic layer 48, as compared with the comparative example, while it exhibits a similar value of exchange coupling *Hua* to that of the comparative example, between the first and second pinned ferromagnetic layers 46a, 46c. This results in a larger magnetoresistive ratio in the specific example.

Furthermore, other specific examples of the aforementioned spin valve film 41 were prepared. These specific examples were designed to include a Ta layer of 5.0nm thickness, a NiFe layer of 2.0nm thickness, a PdPtMn layer of 15.0nm thickness, a CoFeB layer of 1.0nm thickness, a Ru layer of 0.7nm thickness, a CoFeB layer of 1.5nm thickness, a Cu layer as the non-magnetic spacer layer 47, a CoFeB layer of 2.0nm thickness, a Cu layer of 1.0nm thickness and a Ta layer, formed in this sequence over an Al₂O₃-TiC wafer covered with a SiO₂ lamination. The thickness of the Cu layer, namely, the non-magnetic spacer layer 47 was differently set in the individual specific examples, as is apparent from Table 3 shown below. The surface of the Ru layer was simply exposed to the oxygen atmosphere so as to generate the oxide, in the same manner as described above. After a heat treatment regulating the lattice structure in the PdPtMn layer, the inventors examined the magnetoresistive (MR) ratio, the exchange coupling *Hua* established between the CoFeB layers, namely, first and second pinned ferromagnetic layers 46a, 46c, and the exchange coupling *Hin* established between the CoFeB layers, namely, the pinned ferromagnetic layer 46 and the free ferromagnetic layer 48.

**[Table 3]**

| Thickness of Cu Layer [nm] | MR Ratio [%] | Hua [kA/m] | Hin [kA/m] |
|---|---|---|---|
| 1.8 | 7.6 | 59.7 | 5.2 |
| 1.9 | 8.2 | 75.6 | 0.9 |
| 2.0 | 8.0 | 77.2 | 0.02 |
| 2.1 | 8.0 | 79.6 | -0.3 |
| 2.2 | 7.8 | 79.6 | -0.3 |
| 2.3 | 7.7 | 87.5 | -0.3 |

As is apparent from Table 3, it has been confirmed that the exchange coupling *Hin* can sufficiently be suppressed between the pinned and free ferromagnetic layers 46, 48 in the spin valve film 41, including the oxide on the surface of the Ru layer, even when the thickness of the non-magnetic spacer or Cu layer 47 is set in the range between 1.9nm and 2.3nm, for example. Moreover, a higher magnetoresistive ratio can be obtained in the spin valve film 41. The thickness of the Cu layer when smaller than 1.8nm led to deterioration of the magnetoresistive ratio.

In general, the exchange coupling *Hin* must be suppressed between the pinned and free ferromagnetic layers in a spin valve film. A stronger exchange coupling *Hin* between the pinned and free ferromagnetic layers hinders the rotation of magnetization within the free ferromagnetic layer. The spin valve film suffers from reduction in the variation rate of electric resistance. If the non-magnetic spacer layer of a larger thickness is interposed between the pinned and free ferromagnetic layers, the magnetic interaction can be suppressed between the pinned and free ferromagnetic layers.

In previously proposed systems, a spin valve film is designed to include the non-magnetic spacer layer of a larger thickness in the range of 2.8nm and 3.0nm approximately. However, an increased thickness of the non-magnetic spacer layer in this manner tends to induce an increase in the shunt current which is unable to contribute to detection of variation in the electric resistance in the spin valve film. The increased shunt current tends to deteriorate the magnetoresistive ratio of the spin valve film.

In contrast, the present invention provides a magnetoresistive film capable of reducing the thickness of the non-magnetic spacer layer, and at the same time, of reliably achieving an improved magnetroresistive ratio, and a method of making the same.

## Claims

1. A magnetoresistive film comprising:
an antiferromagnetic layer;
a first pinned ferromagnetic layer superposed on the antiferromagnetic layer;
an antiferromagnetic bonding layer superposed on the first pinned ferromagnetic layer;
a second pinned ferromagnetic layer superposed on the antiferromagnetic bonding layer;
a non-magnetic spacer layer superposed on the second pinned ferromagnetic layer;
a free ferromagnetic layer superposed on the non-magnetic spacer layer; and
a compound existing between the antiferromagnetic layer and the second pinned ferromagnetic layer.

2. The magnetoresistive film according to claim 1, wherein said antiferromagnetic layer is a polycrystalline layer of a regulated lattice structure.

3. The magnetoresistive film according to claim 1 or 2, wherein said compound comprises at least one of an oxide, a nitride, a sulfide and a carbide.

4. The magnetoresistive film according to claim 3, wherein said oxide, nitride, sulfide or carbide is a compound consisting of an element included in the antiferromagnetic bonding layer, and oxygen, nitrogen, sulfur or carbon.

5. The magnetoresistive film according to any preceding claim, wherein said antiferromagnetic bonding layer has a thickness in the range between 0.5nm and 0.9nm.

6. The magnetoresistive film according to any preceding claim, wherein said non-magnetic spacer layer has a thickness in the range between 1.9nm and 2.3nm.

7. A method of making a magnetoresistive film, comprising:
forming a material layer on a substrate, said material layer containing an antiferromagnetic metallic element;
forming a first pinned ferromagnetic layer on the material layer;
forming an antiferromagnetic bonding layer on the first pinned ferromagnetic layer;
transforming a part of the antiferromagnetic bonding layer so as to generate a transformed layer at a surface of the antiferromagnetic bonding layer;
forming a second pinned ferromagnetic layer on the antiferromagnetic bonding layer;
forming a non-magnetic spacer layer on the second pinned ferromagnetic layer;
forming a free ferromagnetic layer on the non-magnetic spacer layer; and
effecting a heat treatment on at least the material layer.

8. The method according to claim 7, wherein said transformed layer comprises at least a compound selected from a group consisting of an oxide, a nitride, a sulfide and a carbide.

9. The method according to claim 7 or 8, wherein said antiferromagnetic bonding layer is exposed to a reactive gas in forming the transformed layer.

10. The method according to claim 9, wherein said reactive gas consists of at least one of oxygen and nitrogen.

11. A layered polycrystalline structure film comprising:
a first ferromagnetic crystal layer;
an antiferromagnetic bonding layer formed on the first ferromagnetic crystal layer based on epitaxy;
a second ferromagnetic crystal layer formed on the epitaxial antiferromagnetic bonding layer based on epitaxy; and
a compound existing between the antiferromagnetic bonding layer and the second ferromagnetic crystal layer.

12. The layered polycrystalline structure film according to claim 11, wherein said compound comprises at least one of an oxide, a nitride, a sulfide and a carbide.

13. The layered polycrystalline structure film according to claim 12, wherein said oxide, nitride, sulfide or carbide is a compound consisting of an element included in the antiferromagnetic bonding layer, and oxygen, nitrogen, sulfur or carbon.
